(19) Europäisches Patentamt
European Patent Office
Office européen des brevets

(11) Publication number: **0 474 922 A1**

(12) **EUROPEAN PATENT APPLICATION**

(21) Application number: **90202414.0**

(51) Int. Cl.[5]: **G03F 7/07**, G03C 8/06

(22) Date of filing: **11.09.90**

(43) Date of publication of application:
**18.03.92 Bulletin 92/12**

(84) Designated Contracting States:
**AT BE CH DE DK ES FR GB GR IT LI LU NL SE**

(71) Applicant: **AGFA-GEVAERT naamloze vennootschap**
**Septestraat 27**
**B-2510 Mortsel(BE)**

(72) Inventor: **Vaes, Jos Alfons**
**Moorsemsestraat 245**
**B-3130 Betekom(BE)**

(54) **Photographic DTR mono-sheet material.**

(57) A photographic DTR mono-sheet material is disclosed containing as developing agents hydroquinone or a hydroquinone derivative and 1-phenyl-3-pyrazolidinone or a 1-phenyl-3-pyrazolidinone derivative in such a way that the ratio of said amount of hydroquinone or derivative to said amount of 1-phenyl-3-pyrazolidinone or derivative is not higher than 2.5, all amounts being expressed by weight. Preferably said ratio is comprised between 2.0 and 0.8.

The material shows improved sensitometric storage characteristic.

The mixture of developing agents is preferably composed of hydroquinone itself and 1-phenyl-4,4'-dimethyl-3-pyrazolidinone ("dimethyl-Phenidone").

The developing agents can be distributed between several layers of the DTR material.

Preferably the DTR material is developed by an activator solution.

EP 0 474 922 A1

FIELD OF THE INVENTION

The present invention relates to the composition of a photographic material and more particular to the composition of a diffusion transfer reversal material which upon processing produces a lithographic printing plate.

BACKGROUND OF THE INVENTION

The principles of the silver complex diffusion transfer reversal process, hereinafter called DTR-process, have been described e.g. in US-P 2,352,014 and in the book "Photographic Silver Halide Diffusion Processes" by André Rott and Edith Weyde - The Focal Press - London and New York, (1972).

In the DTR-process non-developed silver halide of an information-wise exposed photographic silver halide emulsion layer material is transformed with a so-called silver solvent into soluble silver complex compounds which are allowed to diffuse into an image-receiving element and are reduced therein with a developing agent, generally in the presence of physical development nuclei, to form a silver image having reversed image density values ("DTR-image") with respect to the black silver image obtained in the exposed areas of the photographic material.

A DTR-image bearing processed material can be used as a planographic printing plate wherein the DTR-silver image areas form the water-repellant ink-receptive areas on a water-receptive ink-repellant background. For example, typical lithographic printing plates are disclosed e.g. in Japanese Examined Patent Publication (Kokoku) 30562/73, Japanese Unexamined Patent Publications (Kokai) Nos. 21602/78, 103104/79, 9750/81 etc.

The DTR-image can be formed in the image-receiving layer of a sheet or web material which is a separate element with respect to the photographic silver halide emulsion material (a so-called two-sheet DTR element) or in the image-receiving layer of a so-called single-support-element, also called mono-sheet element, which contains at least one photographic silver halide emulsion layer integral with an image-receiving layer, usually containing development nuclei, in waterpermeable relationship therewith. It is the latter mono-sheet version which is preferred for the preparation of offset printing plates by the DTR method as disclosed e.g. in GB 1,241,661.

Preferred silver halide solvents are watersoluble thiosulphate compounds such as ammonium and sodium thiosulphate, or ammonium and alkali metal thiocyanates. Further interesting silver halide complexing agents are cyclic imides, preferably combined with alkanolamines, as described in US-P 4,297,430 and US-P 4,355,090. 2-Mercaptobenzoic acid derivatives are described as silver halide solvents in US-P 4,297,429, preferably combined with alkanolamines or with cyclic imides and alkanolamines.

According to a well known conventional embodiment the silver halide emulsion contained in the DTR element is orthochromatically sensitized with a conventional cyanine or merocyanine dye so that said DTR element can be exposed on a process camera using an ordinary light source, e.g. tungsten light. Commercially available DTR materials according to this conventional method which can be processed to lithographic printing plates are marketed e.g. by MITSUBISHI PAPER MILLS LTD under the trade name SILVERMASTER and by AGFA-GEVAERT N.V. under the trade name SUPERMASTER.

According to more recent developments new types of DTR elements are used as recording materials for phototype-setting and image-setting devices which employ laser beams as their output energy source. According to these so-called "direct to plate" methods these laser-exposed DTR materials are transformed in direct-to-use printing plates containing type- and image information, thus avoiding the intermediate steps as in conventional pre-press work flow.

As a consequence these DTR elements must show a spectral sensitivity matching as closely as possible the emission wavelength of the laser beam in question. For example, lithographic DTR elements suited for exposure by helium-neon laser (HeNe) or light emitting diode (LED), both devices emitting in the red region of the visual spectrum, are disclosed in US-P 4,501,811 and Japanese Unexamined Patent Publication (Kokai) Nos. 71055/84 and 75838/85. A commercially available DTR material spectrally sensitized for HeNe exposure is marketed by AGFA-GEVAERT N.V. under the trade name SETPRINT HeNe-plate PP 410 p. On the other hand semiconductor lasers, also called laserdiodes, show some advantages compared to other laser types such as low cost price, small size and long life time. Generally the emission wavelength of these semiconductor laser beams is longer than 700 nm and mostly longer than 750 nm. Suitable photographic materials to be used with semiconductor laser device are disclosed e.g. in Japanese Unexamined Patent Publication (Kokai) No 61752/85 and US-P 4,784,933.

The developing agent or a mixture of developing agents can be present in an alkaline processing solution or in the photographic silver halide emulsion layer material itself or in both of them. In case the

developing agent or a mixture of developing agents is contained exclusively in the photographic silver halide emulsion material, the processing solution can be merely an aqueous alkaline solution that initiates and activates the development, such alkaline solution being referred to hereinafter as "activator solution" to distinguish it from a "developing solution" which contains developing agents. Usually when a photographic DTR-material is intended to serve as lithographic printing plate the developing or activator solution is followed by a so-called neutralization solution containing buffer substances to neutralize the alkaline DTR-material after treatment with the developer or activator bath. Finally the processed material is dried.

The most commonly used mixture of developing agents in DTR mono-sheet materials or developing solutions for such materials consists on the one side of a hydroquinone, meaning hydroquinone itself or one of its known derivatives, and on the other side of a 1-phenyl-3-pyrazolidinone, meaning 1-phenyl-3-pyrazolidinone itself or one of its known derivatives. In this mixture of developing agents 1-phenyl-3-pyrazolidinone (commonly designated in the art as "Phenidone") or derivative constitutes the so-called auxiliary developing agent the molecules of which are regenerated after each oxido-reduction cycle. Therefore it is common practice in existing materials, where the developing agents are partly or exclusively contained in the material itself, to employ a relative small amount of a Phenidone compared to the amount of the hydroquinone which is the main developing agent being consumed in the developing process. For example ratios of hydroquinone(derivative) to Phenidone(derivative) of about 5 are found in commercially available DTR materials. In patent literature mention is made of ratios of developing agents only in rare instances. So GB 1,330,657 discloses a method of manufacturing an aluminium offset printing plate by DTR wherein the concentrations of hydrochinon and Phenidone(derivative) show a ratio of 4:1 to 50:1 when present in a layer.

However it was experimentally found that some DTR materials showing a common ratio of a hydroquinone to a Phenidone suffer from a sensitometric instability in their long term storage properties, resulting in a lowering of the maximal density and the gradation of the developed DTR silver. According to Arrhenius' law these long term storage properties can be simulated by exposing the material to elevated temperature and/or relative humidity for a relative short period, e.g. a few days.

It is an object of the present invention to overcome these sensitometric losses during shelf life thus providing a DTR mono-sheet material which is stable for a long period.

Other objects will become apparent from the description hereafter.

## SUMMARY OF THE INVENTION

The objects of the present invention are realized by incorporating into the DTR mono-sheet material an amount of a hydroquinone and an amount of a 1-phenyl-3-pyrazolidinone ("Phenidone") in such a way that the ratio of said amount of hydroquinone or derivative to said amount of 1-phenyl-3-pyrazolidinone or derivative is not higher than 2.5, all amounts being expressed by weight. By amount is meant the total amount of the respective developing agents which can be distributed over different layers of the DTR material, e.g. the emulsion layer, the image-receiving layer, the antihalation layer or an intermediate layer. Preferably the thus defined ratio is comprised between 2.0 and 0.8.

The developing solution can contain additional amounts of developing agents but preferably the DTR material is developed by an activator solution containing no developing agents at all.

It was a surprise to find that simply raising the amount of a Phenidone in such a way that the ratio of hydroquinone(derivative) to Phenidone(derivative) becomes substantially lower than common practice would counteract the sensitometric losses during storage.

In order to avoid the risk of chemical fogging the extra amount, compared to prior art materials, of a Phenidone is incorporated partly or totally in a non-emulsion layer, e.g. an antihalation layer.

## DETAILED DESCRIPTION OF THE INVENTION

Known derivatives of hydroquinone for use in connection with the present invention include methylhydroquinone and chlorohydroquinone. Known derivatives of 1-phenyl-3-pyrazolidinone for use in connection with the present invention include 1-phenyl-4-monomethyl-3-pyrazolidinone, 1-phenyl-4,4'-dimethyl-3-pyrazolidinone and 1-phenyl-4-hydroxymethyl-4'-methyl-3-pyrazolidinone.

In a preferred embodiment of the present invention the mixture of developing agents consists of hydroquinone (HQ) itself and of 1-phenyl-4,4'-dimethyl-3-pyrazolidinone ("dimethyl-Phenidone"; "DMP").

The photographic DTR mono-sheet element provided in connection with the present invention contains at least one silver halide emulsion layer and a development nuclei containing image-receiving surface layer but other hydrophilic layers may be present such as a hydrophilic layer serving as antihalation layer

between the support and the emulsion layer, a hydrophilic layer intermediate between the emulsion layer and the image-receiving layer, and a backing layer applied at the non-light-sensitive side of the support.

The hydroquinone and the Phenidone used in accordance with the present invention can be present in any of the layers on the light-sensitive side of the support or can be distributed over those layers in any ratio. The total amount of the hydroquinone is preferably comprised between 0.25 and 0.75 g/m $^2$. In a preferred embodiment the hydroquinone is distributed between the emulsion layer and the nuclei containing image-receiving layer. The total amount of the Phenidone is preferably comprised between 0.10 and 0.75 g/m $^2$, of course with the restriction that the maximal ratio of the hydroquinone to the Phenidone is 2.5 according to the invention. In a preferred embodiment the Phenidone is distributed between the emulsion layer and the antihalation layer, present between the support and the emulsion layer. The developing agents can be added to the photographic material in the form of aqueous solutions or dispersions.

According to the present invention the ratio of the amount of the hydroquinone to the amount of the Phenidone is not higher than 2.5. However in order to take most advantage of the present invention said ratio is preferably not higher than 2.0 and in a still more preferred embodiment said ratio is comprised between 2.0 and 0.8.

Conventionally the emulsion layer of the DTR mono-sheet material consists of a single layer but principally a double layer pack or a multiple layer pack are possible. Each layer can contain one emulsion or a mixture of several emulsions. The emulsion or emulsions used in accordance with the present invention preferably consist principally of silver chloride but a fraction of silver bromide preferably ranging from 0 to 40 mole % and/or a fraction of silver iodide preferably ranging from 0 to 10 mole % can be present. The bromide and iodide can be homogeneously distributed over the silver halide grain volume or inhomogeneously distributed, e.g. in a so-called core-shell form. The emulsion grains can further contain one or more dopants preferably elements of group VIII of the Periodic System, e.g. Rhodium or Iridium.

The photographic emulsions can be prepared from soluble silver salts and soluble halides according to different methods as described e.g. by P. Glafkides in "Chimie et Physique Photographique", Paul Montel, Paris (1967), by G.F. Duffin in "Photographic Emulsion Chemistry", The Focal Press, London (1966), and by V.L. Zelikman et al in "Making and Coating Photographic Emulsion", The Focal Press, London (1966).

The photographic silver halide emulsions used according to the present invention can be prepared by mixing the halide and silver solutions in partially or fully controlled conditions of temperature, concentrations, sequence of addition, and rates of addition. The silver halide can be precipitated according to the single-jet method, the double-jet method, or the conversion method. These silver halide particles may have a regular crystalline form such as a cubic or octahedral form or they may have a transition form. They may also have an irregular crystalline form such as a spherical form or a tabular form, or may otherwise have a composite crystal form comprising a mixture of said regular and irregular crystalline forms.

The average size of the silver halide grains may range from 0.10 to 0.70 micron, preferably from 0.25 to 0.45 micron. The size distribution of the silver halide particles of the photographic emulsions to be used according to the present invention can be homodisperse or heterodisperse. A homodisperse size distribution is obtained when 95% of the grains have a size that does not deviate more than 30% from the average grain size.

The emulsions can be chemically sensitized e.g. by adding sulphur-containing compounds during the chemical ripening stage e.g. allyl isothiocyanate, allyl thiourea, and sodium thiosulphate. Also reducing agents e.g. the tin compounds described in BE-P 493,464 and 568,687, and polyamines such as diethylene triamine or derivatives of aminomethane-sulphonic acid can be used as chemical sensitizers. Other suitable chemical sensitizers are noble metals and noble metal compounds such as gold, platinum, palladium, iridium, ruthenium and rhodium. This method of chemical sensitization has been described in the article of R.KOSLOWSKY, Z. Wiss. Photogr. Photophys. Photochem. 46, 65-72 (1951).

The emulsions of the DTR element can be spectrally sensitized according to the spectral emission of the exposure source for which the DTR element is designed.

Suitable sensitizing dyes for the visible spectral region include methine dyes such as those described by F.M. Hamer in "The Cyanine Dyes and Related Compounds", 1964, John Wiley & Sons. Dyes that can be used for this purpose include cyanine dyes, merocyanine dyes, complex cyanine dyes, complex merocyanine dyes, holopolar cyanine dyes, hemicyanine dyes, styryl dyes and hemioxonol dyes. Particularly valuable dyes are those belonging to the cyanine dyes, merocyanine dyes, complex merocyanine dyes.

In the case of a conventional light source, e.g. tungsten light, a green sensitizing dye is needed. A preferred green sensitizing dye in connection with the present invention is represented by the following chemical formula :

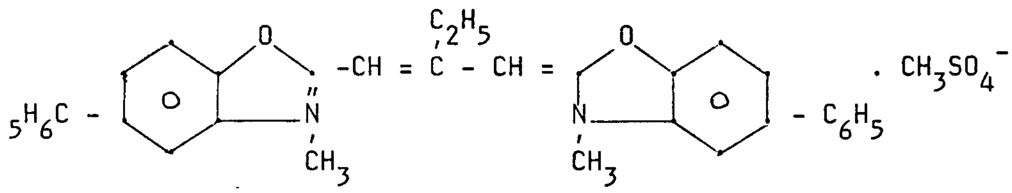

In case of exposure by a red light emitting source, e.g. a LED or a HeNe laser a red sensitizing dye is used. A preferred red sensitizing dye is :

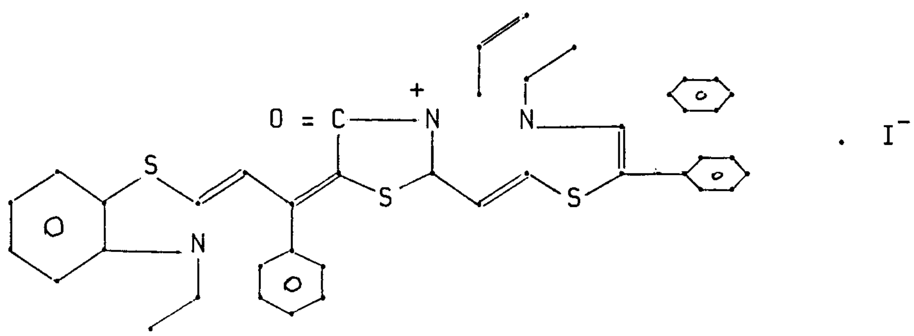

In case of exposure by an argon ion laser a blue sensizing dye is incorporated. A preferred blue sensitizing dye is represented by :

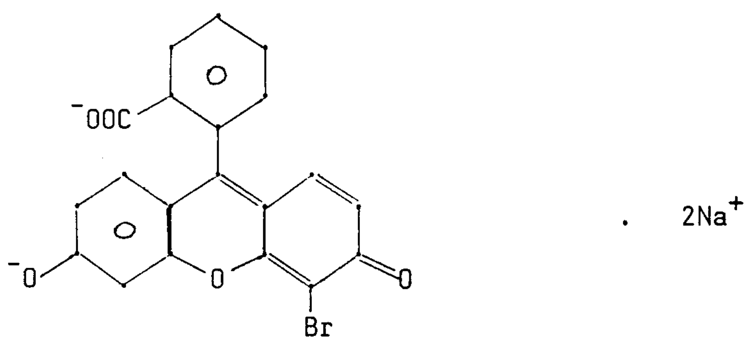

In case of exposure by a semiconductor laser special spectral sensitizing dyes suited for the near infra-red are required. Suitable infra-red sensitizing dyes are disclosed in i.a. US-P Nos 2,095,854, 2,095,856, 2,955,939, 3,482,978, 3,552,974, 3,573,921, 3,582,344, 3,623,881 and 3,695,888. A preferred infra-red sensitizing dye is :

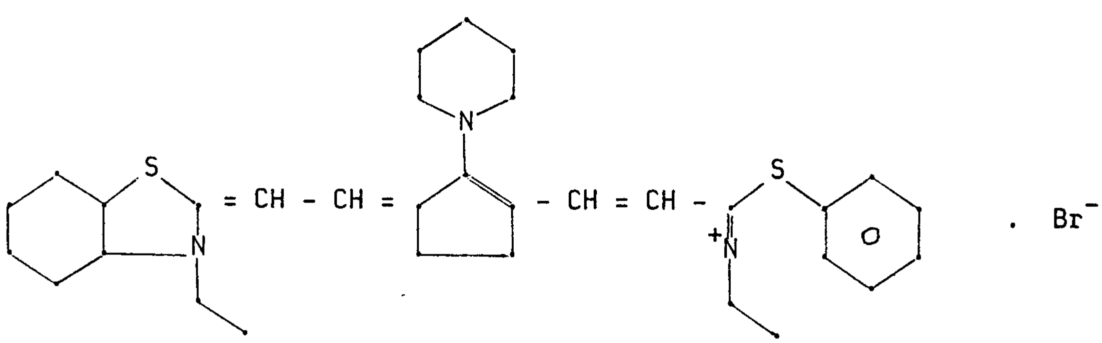

To enhance the sensitivity in the near infra-red region use can be made of so-called supersensitizers in combination with infra-red sensitizing dyes. Suitable supersensitizers are described in Research Disclosure Vol 289, May 1988, item 28952. A preferred supersensitizer is Compound IV of the Disclosure having following formula :

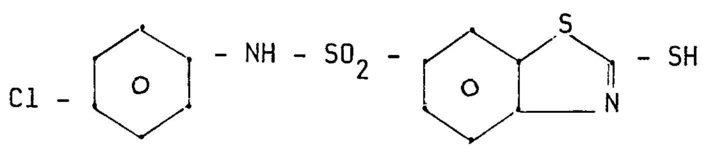

The spectral sensitizers can be added to the photographic emulsions in the form of an aqeous solution, a solution in an organic solvent or in the form of a dispersion.

The silver halide emulsion(s) may contain the usual stabilizers e.g. homopolar or salt-like compounds of mercury with aromatic or heterocyclic rings such as mercaptotriazoles, simple mercury salts, sulphonium mercury double salts and other mercury compounds. Other suitable stabilizers are azaindenes, preferably tetra- or penta-azaindenes, especially those substituted with hydroxy or amino groups. Compounds of this kind have been described by BIRR in Z. Wiss. Photogr. Photophys. Photochem. 47, 2-27 (1952). Other suitable stabilizers are i.a. heterocyclic mercapto compounds e.g. phenylmercaptotetrazole, quaternary benzothiazole derivatives, and benzotriazole. Preferred compounds are mercapto substituted pyrimidine derivatives as disclosed in US-P 3,692,527.

Development acceleration can be accomplished with the aid of various compounds, preferably polyalkylene derivatives having a molecular weight of at least 400 such as those described in e.g. US-P 3,038,805 - 4,038,075 - 4,292,400.

In an especially preferred embodiment the emulsion layer contains a compound which comprises in its molecular structure a group capable of adsorbing to silver halide and a group capable of reducing silver halide. Compounds of this kind have been disclosed in the European Patent Application, filed on 26.02.90 under application No 90.200458.9. In this way a combination of a stabilizing and a development activating function in one compound is achieved. A preferred compound belonging to this class is represented by the following formula :

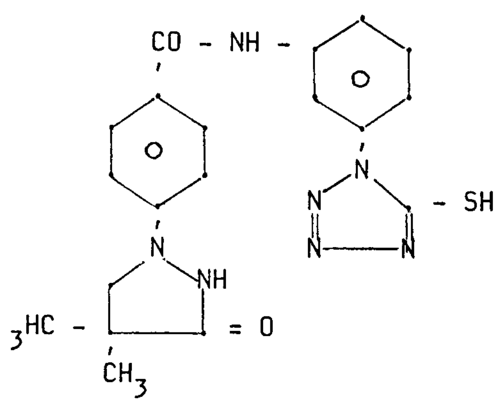

In a preferred embodiment in connection with the present invention a backing layer is provided at the non-light sensitive side of the support. This layer which can serve as anti-curl layer can contain i.a. matting agents e.g. silica particles, lubricants, antistatic agents, light absorbing dyes, opacifying agents, e.g. titanium oxide and the usual ingredients like hardeners and wetting agents. The backing layer can consist of one single layer or a double layer pack.

The hydrophilic layers usually contain gelatin as hydrophilic colloid binder. Mixtures of different gelatins with different viscosities can be used to adjust the rheological properties of the layer. Like the emulsion layer the other hydrophilic layers are coated preferably at a pH value below the isoelectric point of the gelatin. But instead of or together with gelatin, use can be made of one or more other natural and/or synthetic hydrophilic colloids, e.g. albumin, casein, zein, polyvinyl alcohol, alginic acids or salts thereof, cellulose derivatives such as carboxymethyl cellulose, modified gelatin, e.g. phthaloyl gelatin etc.

The hydrophilic layers of the photographic element, especially when the binder used is gelatin, can be hardened with appropriate hardening agents such as those of the epoxide type, those of the ethylenimine type, those of the vinylsulfone type e.g. 1,3-vinylsulphonyl-2-propanol, chromium salts e.g. chromium acetate and chromium alum, aldehydes e.g. formaldehyde, glyoxal, and glutaraldehyde, N-methylol compounds e.g. dimethylolurea and methyloldimethylhydantoin, dioxan derivatives e.g. 2,3-dihydroxy-dioxan, active vinyl compounds e.g. 1,3,5-triacryloyl-hexahydro-s-triazine, active halogen compounds e.g. 2,4-dichloro-6-hydroxy-s-triazine, and mucohalogenic acids e.g. mucochloric acid and mucophenoxychloric acid. These hardeners can be used alone or in combination. The binders can also be hardened with fast-reacting hardeners such as carbamoylpyridinium salts of the type, described in US 4,063,952.

The photographic element used according to the present invention may further comprise various kinds of surface-active agents in the photographic emulsion layer or in at least one other hydrophilic colloid layer. Suitable surface-active agents include non-ionic agents such as saponins, alkylene oxides e.g. polyethylene glycol, polyethylene glycol/polypropylene glycol condensation products, polyethylene glycol alkyl ethers or polyethylene glycol alkylaryl ethers, polyethylene glycol esters, polyethylene glycol sorbitan esters, polyalkylene glycol alkylamines or alkylamides, silicone-polyethylene oxide adducts, glycidol derivatives, fatty acid esters of polyhydric alcohols and alkyl esters of saccharides; anionic agents comprising an acid group such as a carboxy, sulpho, phospho, sulphuric or phosphoric ester group; ampholytic agents such as aminoacids, aminoalkyl sulphonic acids, aminoalkyl sulphates or phosphates, alkyl betaines, and amine-N-oxides; and cationic agents such as alkylamine salts, aliphatic, aromatic, or heterocyclic quaternary ammonium salts, aliphatic or heterocyclic ring-containing phosphonium or sulphonium salts. Preferably compounds containing perfluorinated alkyl groups are used. Such surface-active agents can be used for various purposes e.g. as coating aids, as compounds preventing electric charges, as compounds improving slidability, as compounds facilitating dispersive emulsification and as compounds preventing or reducing adhesion.

The photographic element of the present invention may further comprise various other additives such as e.g. compounds improving the dimensional stability of the photographic element, UV-absorbers, spacing agents and plasticizers.

Suitable additives for improving the dimensional stability of the photographic element are e.g. dispersions of a water-soluble or hardly soluble synthetic polymer e.g. polymers of alkyl (meth)acrylates, alkoxy-(meth)acrylates, glycidyl (meth)acrylates, (meth)acrylamides, vinyl esters, acrylonitriles, olefins, and styrenes, or copolymers of the above with acrylic acids, methacrylic acids, Alpha-Beta-unsaturated dicarboxylic acids, hydroxyalkyl (meth)acrylates, sulphoalkyl (meth)acrylates, and styrene sulphonic acids.

The support of the DTR mono-sheet material may be opaque or transparent, e.g. a paper support or resin support. When a paper support is used preference is given to one coated at one or both sides with an Alpha-olefin polymer, e.g. a polyethylene layer which optionally contains an anti-halation dye or pigment. It is also possible to use an organic resin support e.g. cellulose nitrate film, cellulose acetate film, poly(vinyl acetal) film, polystyrene film, poly(ethylene terephthalate) film, polycarbonate film, polyvinylchloride film or poly-Alpha-olefin films such as polyethylene or polypropylene film. The thickness of such organic resin film is preferably comprised between 0.07 and 0.35 mm. These organic resin supports are preferably coated with a subbing layer which can contain water insoluble particles such as silica or titanium dioxide.

The DTR mono-sheet material in connection with the present invention is exposed in an apparatus according to its particular application, e.g. a conventional process camera containing a conventional light source or a laser containing device. Examples of HeNe laser containing exposure units are the imagesetters LINOTRONIC 300, marketed by LINOTYPE Co, and CG 9600, marketed by AGFA COMPUGRAPHIC, a division of AGFA CORPORATION. An image-setter provided with an Ar ion laser is LS 210, marketed by Dr-Ing RUDOLF HELL GmbH. Exposure units provided with a laserdiode are LINOTRONIC 200, marketed by LINOTYPE Co, and CG 9400, marketed by AGFA COMPUGRAPHIC, a division of AGFA CORPORATION.

The coated and exposed DTR material can be developed by means of a developing solution containing additional developing agents but preferably it is developed by an activator solution containing no developing agents at all. The alkaline developing or activator solution can contain as silver halide complexing agent a thiocyanate compound, e.g. alkali thiocyanate or ammonium thiocyanate, or a thiosulphate compound, e.g. sodium or ammonium thiosulphate, or a mixture of thiosulphate and thiocyanate. Further interesting silver halide complexing agents are cyclic imides, preferably combined with alkanolamines, as described in US-P 4,297,430 and US-P 4,355,090 and 2-mercaptobenzoic acid derivatives as described in US-P 4,297,429, preferably combined with alkanolamines or with cyclic imides and alkanolamines. A preferred silver complexing agent is thiocyanate by which the best DTR silver morphology is produced.

The developing or activator solution preferably also contains a preserving agent having antioxidation

activity, e.g. sulphite ions provided e.g. by sodium or potassium sulphite. For example, the aqueous alkaline solution comprises sodium sulphite in an amount ranging from 0.15 to 1.0 mole/l. Further may be present a thickening agent, e.g. hydroxyethylcellulose and carboxymethylcellulose, fog inhibiting agents, e.g. potassium bromide, potassium iodide and a benzotriazole, calcium-sequestering compounds, anti-sludge agents, and hardeners including latent hardeners. The developing or activator solution can further contain one or more hydrophobizing agents to enhance the ink-receptive properties of the DTR silver image, e.g. those described in US 3,776,728, and US 4,563,410. Preferred compounds are 5-n-heptyl-2-mercapto-1,3,4,-oxadiazol and 3-mercapto-4-acetamido-5-n.heptyl-1,2,4-triazole. Further an inorganic alkali agent, e.g. sodium hydroxide is present in the developing or activator solution to establish a pH value ranging from 12 to 14, preferably at least 12.5. Other alkali agents can be included e.g. secondary and/or tertiary alkanolamines. Finally, to assure a good spread, the developing or activator solution can contain wetting agents, preferably compounds containing perfluorinated alkyl groups.

The developing or activator solution is followed by a neutralization solution. In order to reduce the pH of the wet swollen DTR element leaving the alkaline activator solution, the neutralization liquid contains buffer ions, e.g. phosphate buffer or citrate buffer to establish in said liquid a pH value ranging from 5.0 to 7.0. The neutralization solution can further contain bactericides, e.g. phenol, thymol or 5-bromo-5-nitro-1,3-dioxan as described in European Patent Specification EP 0,150,517. The liquid can also contain substances which influence the hydrophobic / hydrophilic balance of the printing plate obtained after processing of the DTR element, e.g. silica. Finally the neutralization solution can contain wetting agents, preferably compouds containing perfluorinated alkyl groups.

The processing of the DTR material preferably proceeds in an automatically operated apparatus such as RAPILINE 43 SP marketed by AGFA-GEVAERT N.V.. The DTR-process is normally carried out at a temperature in the range of 10 °C to 35 °C. In order to minimize the quality loss due to bath exhaustion, regenerating liquids can be added preferably automatically in proportion to the consumption of processing liquids.

The following examples illustrate the present invention without however, limiting it thereby. All parts, percentages and ratios are by weight unless otherwise indicated.

EXAMPLE 1

A photographic DTR monosheet material (control sample A) was prepared as follows. One side of a transparent polyethyleneterephtalate support was coated with a pack of two backing layers, the other side was coated with an antihalation layer and an emulsion layer. After drying these layers were subjected to a temperature of 40 °C for 5 days and then the emulsion layer was overcoated with a layer containing development nuclei.

The layer nearest to the support of the backing layer pack contained 0.3 g/m$^2$ of gelatin and 0.5 g/m$^2$ of the antistatic agent co(tetraallyloxyethane / methacrylate / acrylic acid-K-salt) polymer. The second backing layer contained 4 g/m$^2$ of gelatin, 0.15 g/m$^2$ of a matting agent consisting of transparent spherical polymeric beads of 3 micron average diameter according to EP 0080225, 0.05 g/m$^2$ of hardening agent triacrylformal and 0.021 g/m$^2$ of wetting agent $F_{15}C_7$-$COONH_4$.

The antihalation layer contained 0.1 g/m$^2$ of carbon black, 3 g/m$^2$ of gelatin and 0.8 g/m$^2$ of silica particles of 5 micron average diameter.

The emulsion was a typical chlorobromide emulsion composed of 98.2 % of chloride and 1.8 % of bromide, having an average grain size of 0.4 micron and containing Rhodium ions as internal dopant. The emulsion was orthochromatically sensitized by means of a compound according to following formula :

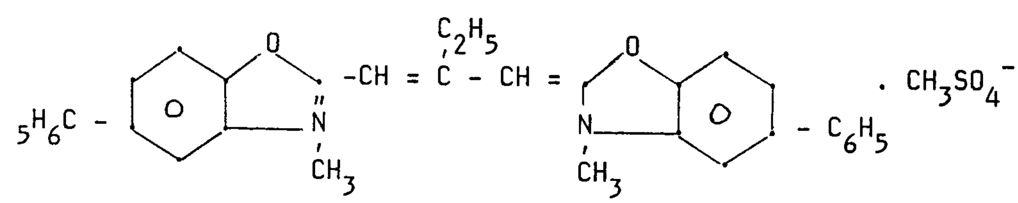

The emulsion was stabilized by a mixture of 1-phenyl-5-mercaptotetrazole and a compound according to following formula :

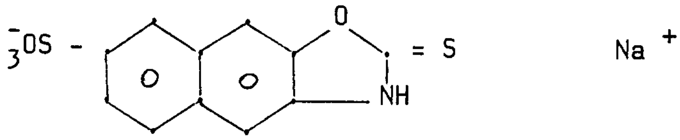

The emulsion layer contained 1.5 g/$m^2$ of silver halide expressed as $AgNO_3$, 0.15 g/$m^2$ of 1-phenyl-4,4'-dimethyl-3-pyrazolidinone ("dimethyl-Phenidone" ; DMP), 0.25 g/$m^2$ of hydroquinone (HQ) and 1.5 g/$m^2$ of gelatin. All gelatine was lime-treated, substantially free of calcium ions (1000 ppm or less) and of the high viscosity type (not less than 85 m.Pa.s at 40 °C for a 10 % solution).

The nuclei containing layer contained PdS nuclei, hydroquinone at 0.4 g/$m^2$ and formaldehyde at 100 mg/$m^2$.

Other DTR materials (samples B to F) were prepared similar to control sample A with the exception that the antihalation layer contained different amounts of extra dimethyl-Phenidone while the amount of hydroquinone remained constant. Table 1 gives a summary of the experiment :

TABLE 1

| sample | DMP in antihalation | Total amount of DMP | HQ | ratio HQ/DMP |
|---|---|---|---|---|
| A | - | 0.15 | 0.65 | 4.3 |
| B | 0.05 | 0.20 | 0.65 | 3.3 |
| C | 0.10 | 0.25 | 0.65 | 2.6 |
| D | 0.15 | 0.30 | 0.65 | 2.2 |
| E | 0.20 | 0.35 | 0.65 | 1.9 |
| F | 0.25 | 0.40 | 0.65 | 1.6 |

The following processing solutions were prepared :

| Activator solution : | |
|---|---|
| sodium hydroxide | 25 g |
| sodium sulphite anh. | 40 g |
| potassium thiocyanate | 20 g |
| 3-mercapto-4-acetamido-5-n.heptyl-1,2,4-triazole | 0.2 g |
| water to make | 1 l |

| Neutralization solution : | |
|---|---|
| citric acid | 10 g |
| sodium citrate | 35 g |
| cysteine | 1 g |
| sodium sulphite anh. | 5 g |
| phenol | 50 mg |
| water to make | 1 l |

| Dampening solution : | |
|---|---|
| water | 880 ml |
| citric acid | 6 g |
| boric acid | 8.4 g |
| sodium sulphite anh. | 25 g |
| ethyleneglycol | 100 g |
| colloidal silica | 28 g |

The DTR samples A to F were subjected to different conditions of temperature and relative humidity for various periods of time. Then the materials were imagewise exposed through the back in a reprocamera. After exposure the samples were treated with the activator solution for 20 seconds at 30 °C, thereupon treated with the neutralization solution for 20 seconds at 25 °C and finally dried. The variations of the maximal density caused by the conditioning treatments were measured.

The printing plates thus prepared were mounted on an offset printing machine (AB Dick 9860, manufactured by AB Dick Co). During the printing run the described dampening solution was used. The lithographic properties printing endurance and background stain were evaluated as follows :

a) printing endurance : number of printed copies before disappearance of ink in the ink accepting areas begins to occur :

X : 2000 - 5000 ;
O : more than 5000 ;

b) background stain : the feeding of paper was started as soon as the inking roll was brought into contact with the surface of the printing plate; copies obtained after 1000 impressions were evaluated as follows :

O : no stain ;
# : partial stain or slight stain over the non-image areas ;
X : heavy stain all over the non-image areas.

In table 2 the results are summarized : the variation of Dmax after 12 hours at 67 °C - 50 % RH; the variation of Dmin, printing endurance and stain after 3 days 57 °C - 34 % RH.

TABLE 2

| sample | Dmax | Dmin | endurance | stain |
|---|---|---|---|---|
| A | -0.07 | -0.07 | X | X |
| B | -0.09 | -0.07 | X | X |
| C | -0.08 | -0.08 | X | # |
| D | -0.03 | -0.01 | O | O |
| E | -0.01 | -0.01 | O | O |
| F | -0.01 | 0 | O | O |

Table 2 illustrates the favourable influence of the use of extra amounts of dimethyl-Phenidone. Below a ratio HQ/DMP of 2.5 an excellent sensitometric stability and perfect printing characteristics were obtained.

EXAMPLE 2

A photographic DTR mono-sheet material (sample G) was prepared as follows. One side of a paper support weighting 135 $g/m^2$ and coated on both sides with polyethylene was subjected to corona discharge and then coated with two layers by a double layer coating technique, the layer nearest to the support being the antihalation layer and the other being the emulsion layer.

The antihalation layer contained carbon black, silica particles of 5 micron average size and lime-treated high viscosity type gelatin at 3 $g/m^2$. The emulsion consisted of silver chloride and was orthochromatically sensitized and stabilized with the same compounds as in example 1. The emulsion layer contained 0.1 $g/m^2$ of dimethyl-Phenidone, 0.15 $g/m^2$ of hydrochinon and 1.0 $g/m^2$ of gelatin. As hardening agent formaldehyde was added at 50 $mg/m^2$. After drying these layers were subjected to a temperature of 40 °C for 5 days and then overcoated with a layer containing PdS nuclei, hydrochinon at 0.4 $g/m^2$ and formaldehyde at 100 $mg/m^2$.

DTR material sample H was prepared similar to sample G with the exception that the antihalation layer

contained an additional amount of 0.24 g/m$^2$ of dimethyl-Phenidone.

Table 3 illustrates the sensitometric results under different storage conditions of DTR samples G and H. The gradations, negative in this case, are measured between 25 % and 75 % of the maximal density. The sensivity differences ( S) are relative log Et values.

TABLE 3

| storage | sample G : HQ/DMP = 5.5 | | | | sample H : HQ/DMP = 1.6 | | | |
|---|---|---|---|---|---|---|---|---|
| conditions | Dmin | Dmax | grad. | S | Dmin | Dmax | grad. | S |
| - | ref. | ref. | -3.1 | ref. | ref. | ref. | -3.6 | ref. |
| 24 h 57°C-34% RH | 0 | -0.04 | -2.4 | -0.01 | 0 | -0.03 | -2.7 | -0.01 |
| 3 d 57°C-34% RH | -0.01 | -0.03 | -2.4 | -0.01 | -0.01 | -0.02 | -3.2 | +0.01 |
| 12 h 67°C-50% RH | +0.01 | -0.02 | -2.9 | -0.01 | 0 | -0.04 | -2.5 | -0.02 |
| 5 d 35°C-80% RH | +0.03 | -0.16 | -1.7 | -0.14 | -0.03 | -0.04 | -2.7 | -0.01 |
| 7 d 35°C | +0.01 | -0.07 | -2.2 | -0.04 | -0.01 | -0.01 | -3.1 | -0.01 |

The superior stability of the material with the low HQ/DMP ratio is clearly illustrated by table 3.

Table 4 illustrates the lithographic results of samples G and H after 3 days storage at 57 ° C - 34 % RH.

TABLE 4

| sample | endurance after 3 d 57° C-34% RH | stain after 3 d 57° C-34% RH |
|---|---|---|
| G | X | X |
| H | O | O |

The superior lithographic quality of sample H compared to sample G is clearly illustrated by table 4.

## Claims

**1.** Photographic diffusion transfer reversal mono-sheet material comprising a support, an emulsion layer and an image-receiving layer, said material containing as developing agents a mixture of hydroquinone or a hydroquinone derivative and 1-phenyl-3-pyrazolidinone or a 1-phenyl-3-pyrazolidinone derivative characterized in that the ratio of the total amount expressed by weight of said hydroquinone or said hydroquinone derivative to the total amount expressed by weight of said 1-phenyl-3-pyrazolidinone or said 1-phenyl-3-pyrazolidinone derivative is not higher than 2.5.

**2.** Photographic diffusion transfer reversal mono-sheet material according to claim 1 wherein said ratio is not higher than 2.0.

**3.** Photographic diffusion transfer reversal mono-sheet material according to claim 1 wherein said ratio is comprised between 2.0 and 0.8.

**4.** Photographic diffusion transfer reversal mono-sheet material according to any of claims 1 to 3 wherein the amount of said 1-phenyl-3-pyrazolidinone or said 1-phenyl-3-pyrazolidinone derivative is distributed between the emulsion layer and an antihalation layer situated between the support and said emulsion layer.

**5.** Photographic diffusion transfer reversal mono-sheet material according to any of claims 1 to 4 wherein said hydroquinone or hydroquinone derivative is present in a total amount comprised between 0.25 and 0.75 g/m $^2$.

**6.** Photographic diffusion transfer reversal mono-sheet material according to any of claims 1 to 4 wherein said 1-phenyl-3-pyrazolidinone or said 1-phenyl-3-pyrazolidinone derivative is present in a total amount comprised between 0.10 and 0.75 $g/m^2$.

**7.** Photographic diffusion transfer reversal mono-sheet material according to any of claims 1 to 6 wherein said hydroquinone or hydroquinone derivative is hydroquinone itself and said 1-phenyl-3-pyrazolidinone or said 1-phenyl-3-pyrazolidinone derivative is 1-phenyl-4,4'-dimethyl-3-pyrazolidinone.

**8.** Photographic diffusion transfer reversal mono-sheet material according to any of claims 1 to 7 wherein said material is developed by an activator solution.

European Patent Office

# EUROPEAN SEARCH REPORT

Application Number

**EP 90 20 2414**

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X,Y | GB-A-2 081 465 (KONISHIROKU PHOTO INDUSTRY CO LTD)<br>* Page 7/8,Example 2,Sample 4 * | 1-8 | G 03 F 7/07<br>G 03 C 8/06 |
| X,Y | GB-A-1 241 662 (AGFA-GEVAERT N.V.)<br>* Example 4 * | 1-8 | |
| Y | EP-A-0 197 202 (AGFA-GEVAERT N.V.)<br>* claims 1, 6, 7 * | 1-8 | |
| Y | PATENT ABSTRACTS OF JAPAN vol. 6, no. 30 (P-103)(908) 23 February 1982,<br>& JP-A-56 150742 (MITSUBISHI SEISHI KK) 21 November 1981,<br>* the whole document * | 1-8 | |

TECHNICAL FIELDS SEARCHED (Int. Cl.5)

G 03 F
G 03 C

The present search report has been drawn up for all claims

| Place of search | Date of completion of search | Examiner |
|---|---|---|
| The Hague | 29 May 91 | BOLGER W. |

CATEGORY OF CITED DOCUMENTS

X : particularly relevant if taken alone
Y : particularly relevant if combined with another document of the same catagory
A : technological background
O : non-written disclosure
P : intermediate document
T : theory or principle underlying the invention
E : earlier patent document, but published on, or after the filing date
D : document cited in the application
L : document cited for other reasons

& : member of the same patent family, corresponding document